# EUROPEAN PATENT APPLICATION

(11) **EP 1 231 635 A1**
(43) Date of publication of application: **14.08.2002**
(21) Application number: 01830082.2
(22) Date of filing: 09.02.2001
(51) Int. Cl.: H01L 23/495, H01L 25/065

(54) **Method for manufacturing an electronic power device and a diode in a same package**

(71) Applicant: STMicroelectronics S.r.l., 20041 Agrate Brianza (Milano) (IT)
(72) Inventor: Magri, Angelo, 95032 Belpasso (Catania) (IT); Fragapane, Leonardo, 95100 Catania (IT)
(74) Representative: Botti, Mario

(57) **Abstract**

A method of manufacturing an electronic structure, which structure comprises a first power device (1) and a second unidirectional device (120), both integrated in the same protective package;
the first device (1) having at least first and second electrodes (8,9) of the first device (1), with said first electrode (8) of the first device (1) being attached to the package; and
the second device (120) having first and second electrodes (170,160) of the second device (120); wherein the first electrode (170) of the second device (120) is superposed on the second electrode (9) of the first device (1) and connected electrically to the second electrode (9) of the first device (1).

## Description

### Application Field

The present invention relates to a method for manufacturing an electronic power device and a diode in a same protective package.

Specifically, the invention relates to a method of manufacturing an electronic structure, which structure comprises a first power device and a second unidirectional device, both integrated in the same package;
said first device having first and second electrodes of said first device, with said first electrode being attached to said package; and
said second device having first and second electrodes of said second device.

The invention also relates to an electronic structure which comprises a first power device and a second unidirectional device realized in package.

The invention relates, particularly but not exclusively, to a method of manufacturing a power device of the IGBT type and a feedback diode in the same package, and the following description is made with reference to this application field, with the only aim to simplify its explanation.

### Prior Art

As is well known, electronic devices of the IGBT (Insulated Gate Bipolar Transistor) type can be used in place of MOS-type field-effect transistors. IGBT devices are used in preference of P-MOS transistors on account of improved electrical characteristics in particular conditions of use. Especially in applications where medium to high voltages, e.g. above 400 V, are provided, a lower voltage drop in the "on" state can be obtained for an IGBT, typically at a working frequency on the order of tens of kHz.

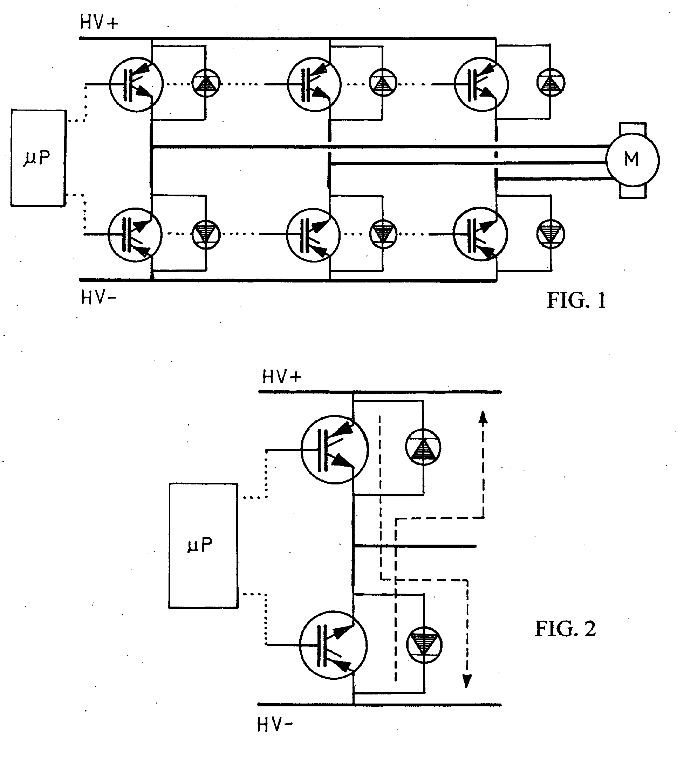

A limitation to the use of IGBT components comes from the lack of a feedback diode therein which be effective to pass a current as the collector-to-emitter bias voltage is reversed, e.g. in motor control applications as shown in Figures 1 and 2. (This diode is instead inherent to the structure of P-MOS devices.) Specifically in motor control applications, each line of a three-phase motor M is controlled by a microcontroller, through an IGBT device having a feedback diode connected in parallel with it.

Solutions to the problem of providing an IGBT component with a feedback diode have been offered in the state of the art.

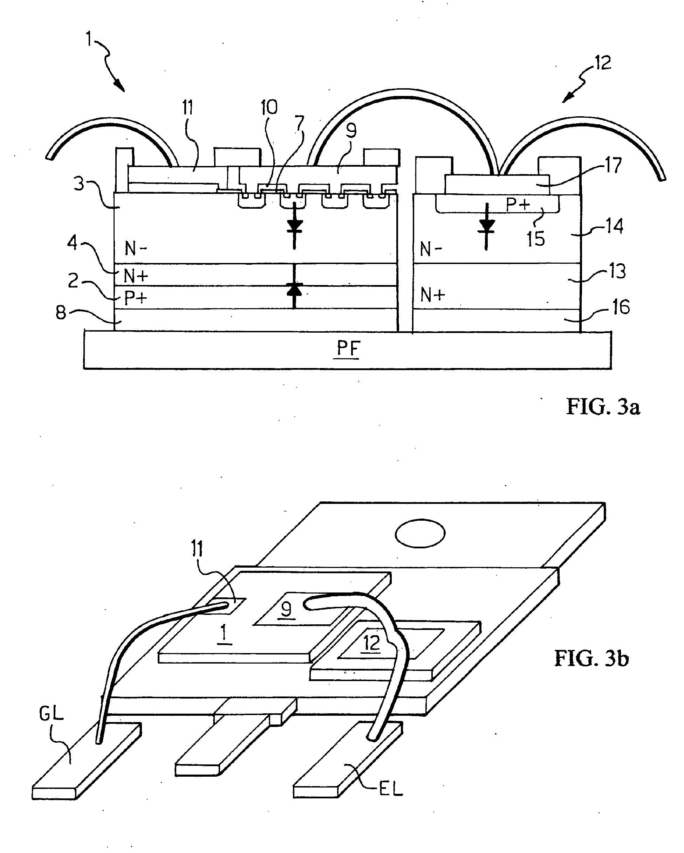

A first prior approach of the prior art to providing a feedback diode, connected between the collector and the emitter of the IGBT, is illustrated by Figures 3a and 3b. The feedback diode is mounted to a common heat-sink type of holder P within a common package. This construction is referred to as "chiP-to-chip".

Figure 3a is a sectional view of a portion of a first chip 1 of a semiconductor material, such as monocrystalline silicon. This chip 1 comprises a substrate 2 doped with P type impurities in a relativity high concentration; an epitaxial layer 3 doped with N type impurities in a relativity low concentration, and denoted with N-; and an N⁺ buffer layer 4 between the substrate 2 and the epitaxial layer 3. At least a diffused region 5 of the P type extends from the surface of the chip 9 into the epitaxial layer 3.

Regions 6 having a high concentration of N dopant are formed within the diffused region 5. Strips of a conductive material, such as doped polycrystalline silicon, denoted 7, extend across the surface of region 5, from region 6 to the epitaxial layer 3, and are isolated from the front surface of the chip by a thin layer of a dielectric material.

A metal electrode 8, in contact with the bottom of the substrate 2, forms the collector electrode of the transistor. A metal electrode 9 on the front surface of the chip contacts the P⁺ regions 5 and N⁺ regions 6, but is isolated from strip 7 by a dielectric layer, e.g. of silicon oxide. The electrode 9 forms the emitter electrode of the IGBT. A metal electrode 11, in contact with a peripheral portion of a region 7, forms the gate electrode of the IGBT.

A second chip 12 comprises a substrate 13 doped with N-type impurities at a relatively high concentration, denoted as N⁺, and an epitaxial layer 14 doped with N-type impurities at a relatively low concentration, denoted as N-. A diffused region 15 of the P type extends from the chip 12 surface into the epitaxial layer 14.

A metal electrode 16, in contact with the bottom of the substrate 13, forms the cathode of the diode. A metal electrode 17, in contact with the diffused region in the front surface of the chip, forms the anode of the diode.

Figure 3b is a perspective view, not drawn to scale, of the chips 1 and 12 as bonded to the same holder in the package. Also shown are connections of the two interconnected devices to terminals GL, EL of the package P.

Although advantageous on several aspects, this prior solution has a drawback in that, when the devices are realized with comparable geometries and compatible locations of the connection pads, the space inside the package is not optimized. Thus, packages having a much larger chip-accommodating area than the silicon (IGBT plus diode) area must be used. Even if a "ad hoc" design is implemented, such as by forming the IGBT and diode with rectangular outlines, the maximum silicon area inside the package would still be less than ideal, by reason of such assembly constraints as chip spacings, relative locations of pads, etc.

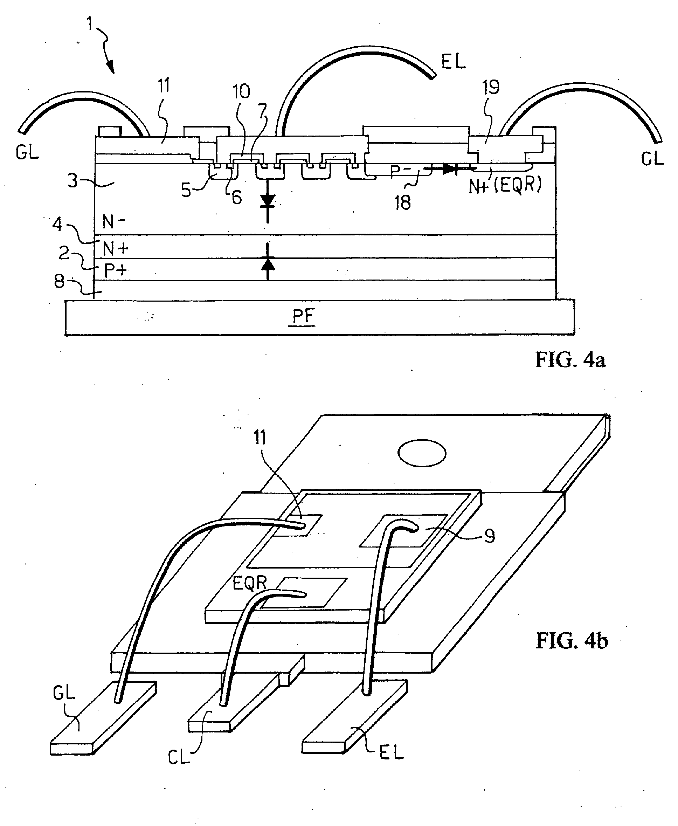

A second prior solution, directed to obviate the above drawback, provides for the feedback diode to be formed in the same chip as the IGBT, utilizing an EQR (EQuipotential Ring) present on the IGBT chip and, accordingly, the diode which creates between an edge structure and the EQR, as shown in Figures 4a and 4b.

The device of these Figures has identical elements with those of the structure shown in Figure 3a denoted by the same reference numerals. As mentioned above, this device differs from the previously described one in that the diode is formed in the same substrate as the IGBT.

In particular, a diffused region 18 of the P- type is provided about the periphery of one of the diffused regions 5. An additional metal electrode 19 establishes ohmic contact to the epitaxial layer 3 through a diffused region 20 which is heavily doped with N dopant and formed in the epitaxial layer 3.

While substantially achieving its object, this prior solution also has drawbacks. In fact, the diode dimension of design is restricted by the device being required to support high voltages, so that the side dimension of the diode has to be sufficiently large (greater than 60 µm), while its perimeter is limited by the package own size.

In addition, where the device manufacturing process includes a so-called "lifetime killing" step, the diode DC voltages are greatly increased by a diminished injection of carriers from the IGBT backside.

The underlying technical problem of this invention is to provide a method of manufacturing power devices, having feedback diodes connected in parallel therewith, with appropriate structural and functional features to optimize the size and geometries of individual devices, as well as to overcome the limitations of the prior art methods.

### Summary of the Invention

The principle on which the present invention stands is one of arranging for an IGBT device and NP diode to be stacked together in mutual electrical contact.

Based on the above principle, the technical problem is solved by a method as previously indicated and defined in the characterizing part of Claim 1.

The problem is further solved by a structure as previously indicated and defined in the characterizing part of Claim 9.

The features and advantages of a device according to the invention will be apparent from the following description of an embodiment thereof, given by way of non-limitative example with reference to the accompanying drawings.

### Brief Description of the Drawings

In the drawings:
Figure 1 illustrates an exemplary application of a power device incorporating a feedback diode;
Figure 2 is a detail view of the application shown in Figure 1;
Figure 3a is a sectional view taken through a portion of a semiconductor material chip containing a conventional device;
Figure 3b is a perspective view of the chip shown in Figure 3a, as mounted to a holder structure;
Figure 4a is a sectional view taken through a portion of a semiconductor material chip containing a conventional device;
Figure 4b is a perspective view of the chip shown in Figure 4a, as mounted to a holder structure;
Figure 5a is a sectional view taken through a portion of a semiconductor material chip containing a device formed by the method of this invention; and
Figure 5b is a perspective view of the chip shown in Figure 5a, as mounted to a holder structure.

### Detailed Description

The drawing views show an electronic structure which comprises a power device 1, e.g. an IGBT, connected in parallel with a unidirectional device 120, e.g. a feedback diode.

In the structure shown in these figures, elements which are identical with those of Figures 3a and 4a, are denoted by the same reference numerals.

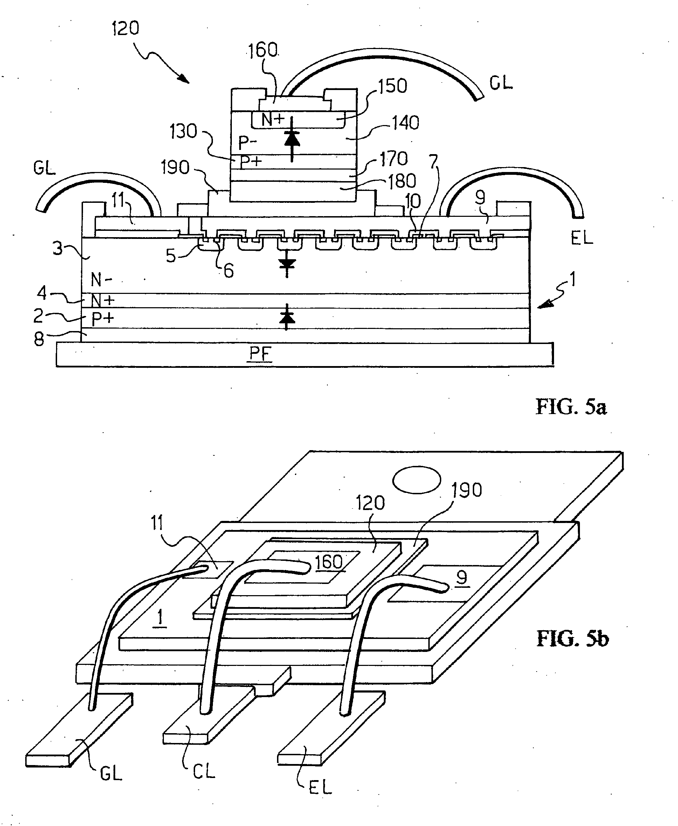

Figure 5a shows a cross-section of a portion of a chip 1 made of a semiconductor material, such as monocrystalline silicon. The chip 1 comprises: a substrate 2 doped with impurities of the P type at a relatively high concentration, denoted as P⁺; an epitaxial layer 3 doped with impurities of the N type at a relatively low concentration, denoted as N-; and an N⁺ buffer layer 4 provided between the substrate 2 and the epitaxial layer 3. At least a diffused region 5 of the P type extends from the surface of the chip 9 into the epitaxial layer 3.

Formed within the at least a diffused region 5 are high doped regions 6 of the N type. Strips 7 of a conductive material, e.g. doped polycrystalline silicon, are locate above the surface of regions 5 and extend from region 6 into the epitaxial layer 3, being isolated from the front surface of the chip by a thin layer of a dielectric material.

A metal electrode 8, in contact with the bottom of the substrate 2, forms the collector electrode of the transistor. This electrode is bonded to the frame PF of the protective package.

A metal electrode 9, in contact with the P⁺ regions 5 and N⁺ regions 6 on the front surface of the chip, but being isolated from the strip 7 by a dielectric layer 10, e.g. of silicon oxide, forms the emitter electrode of the IGBT. A metal electrode 11, in contact with a peripheral portion of one region 7, forms the gate electrode of the IGBT.

According to the invention, a conductive layer 180 is deposited onto a portion of the last-mentioned metal electrode 11 and aligned with it.

Advantageously, this conductive layer 180 is a layer of a bonding compound or conductive glue.

A chip 120 is then placed onto the conductive layer 180. This device 120 comprises: a substrate 130 which is doped with impurities of the P type at a relatively high dopant concentration, denoted as P⁺; and an epitaxial layer 140 which is doped with impurities of the P type at a relatively low dopant concentration, denoted as P-. A diffused region 150 of the N type extends into the epitaxial layer 140 from the surface of the chip 120. A first metal electrode 170 is bonded on a first side to the substrate 130, and glued onto the layer 180 with the opposite side from the first. A second metal electrode 160, in contact with the top surface of the substrate 130, forms the diode cathode. The electrode 160 includes an area set aside for conventional bonding to connect the cathode to a respective terminal.

Advantageously, the electrode 170 comprises a triad of chromium, nickel and gold layers.

A conventional chip-on-chip assembly procedure is followed in this invention, whereby the conductive layer 180 includes a layer of a conductive adhesive material for attaching the IGBT emitter electrode to the anode of the diode NP. The cathode of the diode is bonded conventionally to the collector through its respective terminal CL, as shown schematically in Figure 5b.

Advantageously, the diode 120 will be a comparable size with that area of the IGBT 1 which is reserved for accommodating the diode in conformity with known rules of the chip-on-chip technique.

A preferred embodiment of the IGBT 1 and diode 120 has been disclosed for simplicity; alternatively, these devices could be realized using standard techniques.

According to the invention, there are provided on the IGBT emitter electrode: an area for bonding to the gate electrode lead, an area for bonding to the emitter electrode lead, and an area for accommodating the diode in place. The relative positions of the above three areas will vary with the package type. By way of example only, the contact areas may be situated as shown in the drawings. All three areas may be obtained from standard metal and passivating layers provided by the IGBT manufacturing process. The electrode-forming conductive layer may be aluminum, and the passivating layer nitride. The area for the diode may contain fingers of the gate electrode, on condition that such fingers are covered with the passivating layer in a suitable way to keep them electrically isolated from the conductive adhesive material used for diode emplacement.

Advantageously, a second metal layer (wettable metal) 190, e.g. comprising triple layers of titanium, nickel and gold, may be deposited onto the surface of the diode accommodating area to improve the quality of the emitter electrode-to-diode contact. Where this is the choice, the IGBT manufacturing process should be altered to include the following additional steps:
- forming the second metal layer 190;
- masking to define the area for diode accommodation; and
- selectively etching away the metal layer 190 to uncover the diode accommodating area.

To summarize, the method for manufacturing the structure of this invention comprises the following steps:
- positioning the IGBT device onto the package frame PF, and bonding it thereto by any standard techniques for electronic devices;
- coating the IGBT area which is to accommodate the diode with a layer of a conductive adhesive material, in conformity with the chip-on-chip technique; (advantageously, the adhesive material will be a variety which can be normally used for bonding the IGBT to the package frame)
- positioning the diode on the die-attach area of the IGBT, and applying the required curing procedure;
- completing the inventive structure by bonding the gate, cathode, and emitter leads to their respective gate GL, collector CL, and emitter EL terminals on the package.

Advantageously, the package should provide, as by a special lead, for shorting the diode cathode to the IGBT collector.

To summarize, the invention has the following advantages:
- the IGBT is allowed to fill the package area completely; and
- either devices, being independent of each other, can be realized by their most appropriate techniques.

In conclusion, the invention provides a hybrid diode integration whereby all the package area is utilized, for improved performance of both the IGBT and the diode.

To close with, the method of this invention can be advantageously applied to establish connection of a power device to a unidirectional device in a stacked arrangement. In the preferred embodiment of the invention, the unidirectional device is connected between the collector electrode and the emitter electrode of the power device; alternatively, the unidirectional device could be connected to other terminals of the power device or connected to different terminals of the protective package.

## Claims

1. A method of manufacturing an electronic structure, which structure comprises a first power device (1) and a second unidirectional device (120), both integrated in the same protective package;
said first device (1) having at least first and second electrodes (8,9) of said first device (1), with said first electrode (8) being attached to said package; and
said second device (120) having first and second electrodes (170,160) of said second device (120); **characterized in that**:
said first electrode (170) of said second device (120) is superposed on said second electrode (9) of said first device (1), and connected electrically to said second electrode (9) of said first device (1).

2. A method according to Claim 1, **characterized in that** the electrical connection is provided by an adhesive layer that is electrically conductive (180,190).

3. A method according to Claim 2, **characterized in that** said layer of conductive adhesive material (180) is formed on said second electrode of said first device (1).

4. A method according to Claim 2, **characterized in that** said layer of conductive adhesive material (180) comprises a first metal layer (190) deposited onto the first electrode (8) of said first device (1), and comprises a second layer of bonding compound (180) formed over said metal layer.

5. A method according to Claim 2, **characterized in that** said metal layer (190) comprises triple titanium, nickel, and gold layers.

6. A method according to Claim 1, **characterized in that** said second electrode (160) of said second device (120) is connected to a terminal of the protective package.

7. A method according to Claim 6, **characterized in that** said package terminal is connected to the first electrode (8) of said first device (1).

8. A method according to Claim 2, **characterized in that** it comprises the following steps:
- forming a first substrate (2), having a first type of conductivity, over the first electrode (8) of said first device (1);
- forming a first layer (3), having a second type of conductivity, over said substrate (2);
- forming at least a first region (6), having the first type of conductivity, in said layer (3);
- forming said second electrode (9) of said first device (1) on the first layer (3) and on said at least a first region (6);
- forming said conductive layer (180,190) over a portion of said second electrode (9) of said first device (1);
- forming said first electrode (170) of said second device (120) in said conductive layer (180,190);
- forming a second substrate (130) with the first type of conductivity over said first electrode (170) of said second device (120);
- forming a second layer (140) with the second type of conductivity over said second substrate (130);
- forming a second region (150) with the second type of conductivity deeply in said second layer (140);
- forming said second electrode (160) of said second device (120) on the second layer (140) in contact with said second region (150).

9. An electronic structure comprising a first power device (1) and a second unidirectional device (120) integrated in the same protective package, wherein said first device (1) comprises:
a first substrate (2), having a first type of conductivity and a surface arranged to form the structure bottom;
a first layer (3), having a second type of conductivity and being formed over said substrate (2);
at least a first region (6), having the first type of conductivity and extending deeply from the surface of said first layer (3);
a first electrode (8) of said first device (1) in contact with a surface with the structure bottom, and with the opposite surface with the package frame;
a second electrode (10) of said first device (1) formed in the first layer (3) and in contact with said at least a first region (6);
said electronic structure being **characterized in that** it comprises:
a conductive layer (180,190) in contact with at least a portion of said second electrode (10);
said second unidirectional device in contact with said conductive layer, and comprising:
a second substrate (130) having the first type of conductivity;
a second layer (140) having the second type of conductivity and being formed over said first substrate (130);
a second region (150) having the second type of conductivity and extending deeply from the surface of said layer (140);
a first electrode (170) of said second device (120) in contact with a surface with the second substrate (130), and with the other surface with said conductive layer (180,190);
a second electrode (160) of said second device (120) formed on the second layer (140) and in contact with said second region (150);

10. An electronic structure according to Claim 9, **characterized in that** said conductive layer (180,190) comprises a adhesive layer (180) and a metal layer (190).

11. An electronic structure according to Claim 10, **characterized in that** said metal layer (190) comprises triple titanium, nickel, and gold layers.

12. An electronic structure according to Claim 9, **characterized in that** said second electrode (160) of said second device (120) is connected to the first electrode (8) of said first device (1).
